# EUROPÄISCHE PATENTSCHRIFT

(11) **EP 1 545 895 B1**
(45) Veröffentlichungstag und Bekanntmachung des Hinweises auf die Patenterteilung: **12.04.2006**
(21) Anmeldenummer: 03807828.3
(22) Anmeldetag: 01.10.2003
(51) Int. Cl.: B41M 5/382, H01L 51/40

(54) **VERFAHREN ZUR MIKROSTRUKTURIERUNG MITTELS ORTSSELEKTIVER SUBLIMATION**
METHOD FOR MICROSTRUCTURING BY MEANS OF LOCALLY SELECTIVE SUBLIMATION
PROCEDE DE MICROSTRUCTURATION PAR SUBLIMATION SELECTIVE

(30) Priorität: 04.10.2002 DE 10246425
(43) Veröffentlichungstag der Anmeldung: 29.06.2005
(73) Patentinhaber: Technische Universität Braunschweig, 38106 Braunschweig (DE)
(72) Erfinder: BECKER, Eike, 38118 Braunschweig (DE); HEITHECKER, Dirk, 38118 Braunschweig (DE); METZDORF, Dirk, 38104 Braunschweig (DE); JOHANNES, Hans, Hermann, 38159 Vechelde (DE); DOBBERTIN, Thomas, 38114 Braunschweig (DE); SCHNEIDER, Daniel, 38118 Braunschweig (DE); KOWALSKY, Wolfgang, 38116 Braunschweig (DE)
(74) Vertreter: Döring, Roger
(86) Internationale Anmeldenummer: PCT/EP2003/010863
(87) Internationale Veröffentlichungsnummer: WO 2004/033223

(56) Entgegenhaltungen:
- WO-A-02/22374
- US-A1- 2002 098 614
- US-B1- 6 284 307

## Beschreibung

Die Erfindung bezieht sich auf ein Verfahren zur Mikrostrukturierung mittels ortsselektiver Sublimation, bei welchem zur Herstellung von Mustern oder Bildern aus organischen Elektrolumineszenz-Bauelementen ein auf einem Träger vorhandenes, niedermolekulares Emissionsmaterial durch Sublimation an den Stellen eines Substrats aufgetragen wird, die einem zu erzeugenden Muster oder Bild entsprechen (US-Z "Applied Physics Letters", Vol. 74, Nummer 13, 29. März 1999, Seiten 1913 bis 1915).

Ein solches Verfahren wird mit Vorteil bei der Herstellung von Displays verwendet. Darüber hinaus ist es beispielsweise auch für die Realisierung von Laserstrukturen oder Modulatorstrukturen auf der Basis organischer Materialien einsetzbar. Ein Display besteht aus einzelnen Bildpunkten ("Pixeln"), die einzeln elektrisch ansteuerbar sind und zur Darstellung von beliebigen Mustern oder Bildern verwendet werden. Displays dienen beispielsweise als visuelle Schnittstelle zwischen Mensch und Maschine. Es können auch Monitore von Computern oder Mobiltelefonen sein. Da das Verfahren zur Mikrostrukturierung für alle angegebenen Anwendungsfälle i. w. gleich ausgeführt wird, beziehen sich die folgenden Angaben, stellvertretend für alle anderen Anwendungsmöglichkeiten, auf die Herstellung von Displays.

Displays können einfarbig oder auch mehrfarbig ausgeführt sein. Sogenannte RGB-Displays bestehen aus den drei Farben Rot, Grün und Blau. Wenn an ein Display eine elektrische Spannung angelegt wird, beginnen die in demselben enthaltenen Elektrolumineszenz-Bauelemente zu leuchten.

Ein organisches Elektrolumineszenz-Bauelement ist beispielsweise eine "Organic Light Emitting Diode" - im folgenden kurz als "OLED" bezeichnet. OLEDs haben zur Erzeugung von Mustern - sogenannten Displays - auf ebenen Unterlagen große Vorteile, und zwar wegen ihres relativ einfachen Aufbaus und weil nichtkristalline Materialien verwendet werden. Diese Vorteile gelten besonders gegenüber anderen Displayarten, wie Flüssigkristall-Anzeigen oder Katodenstrahlröhren. OLEDs können aus polymeren (PLED) oder aus niedermolekularen (SMOLED) organischen Materialien hergestellt werden.

Verfahren zur Herstellung von OLEDs aus PLEDs und SMOLEDs sind an sich bekannt. Für PLEDs verwendbare Materialien können beispielsweise in gelöster Form mit Drucktechniken (Injekt, Siebdruck) in einem additiven Prozess nebeneinander aufgebracht werden. Das ist für SMOLEDs nicht möglich. SMOLEDs werden in bekannter Technik durch Sublimation der entsprechenden Materialien aus Verdampfungsquellen im Hochvakuum hergestellt. Dabei scheidet sich das sublimierte Material aus der Gasphase auf einem Substrat ganzflächig als dünner Film ab. Eine Strukturierung des mit dieser Technik erzeugten ganzflächigen Films ist meist nur mit großem Aufwand möglich, da die verwendeten niedermolekularen Materialien leicht beschädigt werden können. Auch eine Unterbrechung des Vakuums zur Durchführung einer Strukturierung vermindert die Qualität der SMOLEDs drastisch. Das gilt in erhöhtem Maße für vollfarbige Displays, für die pro Bildpunkt drei eng benachbarte Pixel mit den Emissionsfarben Rot, Grün und Blau abgeschieden werden müssen. Hier muß zusätzlich sichergestellt werden, daß das lokale Aufbringen der unterschiedlichen Pixel bzw. von organischen Schichten ohne Schädigung von bereits vorhandenen Schichten möglich ist.

Bei dem bekannten Verfahren nach der eingangs erwähnten US-Z "Applied Physics Letters" werden dazu als "Schattenmasken" bezeichnete Masken eingesetzt. Dabei wird das Display-Substrat vor der Sublimation des organischen Materials durch eine Maske abgedeckt. Die Maske befindet sich in geringem Abstand vor dem Substrat. Sie hat nur dort Öffnungen, wo ein Pixel des organischen Materials entstehen soll. Durch ein Verschieben der Maske gegenüber dem Substrat um jeweils einen Pixelabstand zwischen den Sublimationschritten können so auch die Materialien für unterschiedliche Farben selektiv aufgebracht werden. Aufgrund der notwendigen hohen Auflösung der Matrixstruktur muß eine bei diesem Verfahren eingesetzte Maske als sehr feines Gitter aufgebaut sein. Darüber hinaus ist eine geringe Materialstärke der Maske zweckmäßig. Beide Anforderungen führen zu einer nur geringen mechanischen Stabilität der Maske. Insbesondere bei größeren Displays wird daher die exakte Positionierung und Fixierung der mechanisch labilen Maske schwierig. Durch die ständige Abscheidung von sublimiertem Material auf der Maske werden ihre Öffnungen außerdem schnell zugesetzt, so dass eine häufige Reinigung oder ein häufiger Austausch der Maske erforderlich sind.

Der Erfindung liegt die Aufgabe zugrunde, das eingangs geschilderte Verfahren zu vereinfachen.

Diese Aufgabe wird gemäß der Erfindung durch das Verfahren des Anspruchs 1 dadurch gelöst,
- dass zunächst ein folienartiger Träger aus temperaturbeständigem Material ganzflächig mit dem Emissionsmaterial beschichtet wird,
- dass danach der beschichtete Träger und das Substrat in einer Vakuumkammer dicht nebeneinander und parallel zueinander positioniert werden, wobei die mit dem Emissionsmaterial beschichtete Seite des Trägers dem Substrat zugewandt ist, und
- dass anschließend der Träger auf seiner nicht beschichteten Seite lokal an den Stellen, welche dem auf dem Substrat zu erzeugenden Muster oder Bild entsprechen, kurzzeitig auf eine für die Sublimation des Emissionsmaterials ausreichende Temperatur erhitzt wird.

Bei diesem Verfahren wird zunächst eine Folie - im folgenden kurz "Trägerfolie" genannt - aus einem temperaturbeständigen Material, wie beispielsweise Polyimid, mit einem Emissionsmaterial ganzflächig beschichtet. Zur selektiven Übertragung des Emissionsmaterials auf das für die Abscheidung eines Musters oder Bildes vorgesehene Substrat - im folgenden kurz "Display-Substrat" genannt - wird dieses dann in einer Vakuumkammer in geringem Abstand gegenüber der Trägerfolie so positioniert, dass die mit dem Emissionsmaterial beschichtete Seite dem Display-Substrat zugewandt ist. Durch kurzzeitiges lokales Erhitzen der Trägerfolie auf ihrer unbeschichteten Seite wird das Emissionsmaterial sublimiert, wobei es sich auf dem Display-Substrat niederschlägt. Die Ausdehnung des Bereiches, der mit dem Material beschichtet wird, entspricht dabei aufgrund des geringen Abstands zwischen der Trägerfolie und dem Display-Substrat sehr genau der Ausdehnung des aufgeheizten Bereiches.

Die Trägerfolie kann mit einfachen Verfahren sehr schnell und kostengünstig mit dem zu sublimierenden organischen Material beschichtet werden. Wenn auf die Trägerfolie beispielsweise in aufeinanderfolgenden Bereichen Schichten aus verschiedenen organischen Materialien aufgebracht werden, können durch einen einfachen Vorschub der Trägerfolie zwischen zwei Sublimationsschritten Stapel aus organischen Schichten oder bei entsprechender Ansteuerung der Heizelemente nebeneinanderliegende Pixel mit unterschiedlichen Emissionsfarben in einem ununterbrochenen Verfahren hergestellt werden. Es können aber auch getrennte Trägerfolien verwendet werden, die mit den unterschiedlichen organischen Materialien beschichtet sind und nacheinander in Position gebracht werden.

Die dünne organische Schicht aus dem Emissionsmaterial und die sie tragende Trägerfolie haben eine geringe Wärmekapazität. Die lokale Aufheizung einschließlich der vollständigen Übertragung des Emissionsmaterials auf das Display-Substrat kann daher innerhalb von Sekundenbruchteilen erfolgen. Da die lokale Erhitzung in eng begrenzten Bereichen erfolgt, läßt sich mit dem Verfahren eine hohe laterale Auflösung erzielen. Das lokale Erhitzen kann durch feinstrukturierte elektrische Heizelemente oder durch Laserstrahlung in Verbindung mit entsprechenden Optiken erfolgen. Dabei kann - wie schon erwähnt - in beiden Fällen die Übertragung der Struktur sowohl für alle Pixel gleichzeitig als auch für einzelne Spalten oder Pixel nacheinander erfolgen. Sowohl bei Verwendung von elektrischen Heizelementen als auch bei einer strahlungsoptischen Erhitzung werden in der Vakuumkammer keine mechanisch beweglichen Teile benötigt.

Für die Einstellung der Emissionsfarbe kann die Trägerfolie auch mit zwei aufeinanderfolgenden, niedermolekularen Schichten, einem Material A einerseits und einem Material B andererseits beschichtet werden. Das Material A wird als Wirtsmaterial bezeichnet und Material B als Gastmaterial. Auf der Trägerfolie sind die beiden Materialien nicht durchmischt. Nach dem Sublimationsschritt ist auf dem Display-Substrat eine durchmischte Schicht entstanden, in welcher das Material A mit dem Material B dotiert ist. Eine Lichtemission erfolgt aus dem Material B. Das Material B bestimmt die jeweilige Emissionsfarbe.

Das Verfahren nach der Erfindung wird anhand der Zeichnungen als Ausführungsbeispiel erläutert.

### Es zeigen:

Fig. 1 schematisch einen Ablauf für das Verfahren nach der Erfindung.
Fig. 2 die Anordnung von Trägerfolie und Display-Substrat während des Verfahrensablaufs.

Eine aus einem temperaturbeständigen Material, beispielsweise aus Polyimid, bestehende Trägerfolie 1 wird einer Anordnung 2 zugeführt, in welcher auf einer Seite derselben ein Emissionsmaterial beispielsweise durch Sublimation abgeschieden wird. Die andere Seite der Trägerfolie 1 bleibt unbeschichtet. Es entsteht auf der entsprechenden Seite der Trägerfolie 1 ganzflächig eine festhaftende, dünne Schicht aus dem Emissionsmaterial. Die Trägerfolie 1 kann beispielsweise etwa 100 *µ*m dick sein. Sie kann auch aus einem anderen temperaturbeständigen Material als Polyimid bestehen. Die Schicht aus dem Emissionsmaterial kann eine Dicke von etwa 10nm-1*µ*m haben. Die Anordnung 2 kann eine Hochvakuumkammer mit üblichen Sublimationsquellen sein. Sie kann aber auch als Tauch-, Sprüh- oder Druckeinrichtung ausgeführt sein. Das Emissionsmaterial ist ein niedermolekulares, organisches Material, wie beispielsweise Aluminium-tris(8Hydroxychinolin) (kurz: Alq₃,Emissionsfarbe Grün) oder mit 4-(Dicyanomethylen)-2-methyl-6-(p-dimethylaminostyryl)-4H-pyran (kurz: DCM) dotiertes Alq₃ (dann kurz DCM: Alq₃, Emissionsfarbe Rot) oder 2,2',7,7'-tetrakis(2,2-diphenylvinyl)spiro-9,9'-bifluorene (kurz: Spiro-DPV-Bi, Emissionsfarbe Blau).

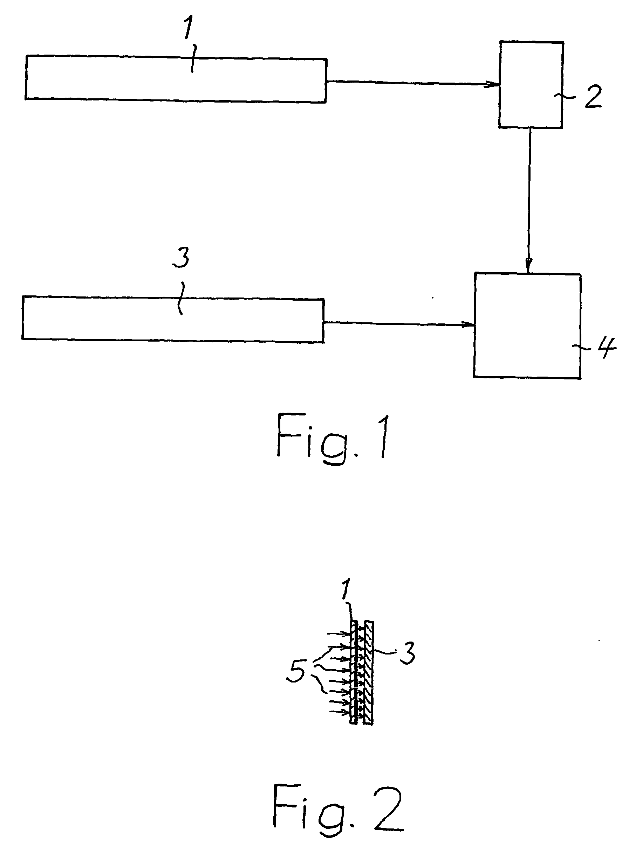

Die mit dem Emissionsmaterial beschichtete Trägerfolie 1 wird zusammen mit einem Display-Substrat 3 in eine Vakuumkammer 4 gebracht. Trägerfolie 1 und Display-Substrat 3 werden darin entsprechend Fig. 2 parallel zueinander und dicht nebeneinander positioniert. Ihr Abstand voneinander liegt auf der Skala der gewünschten-Auflösung etwa zwischen 5 *µ*m und 200 *µ*m. In bevorzugter Ausführungsform wird beispielsweise ein Abstand von 50 *µ*m eingestellt.

Zur Aufbringung des Emissionsmaterials an bestimmten Stellen auf das Display-Substrat 3 wird die Trägerfolie 1 entsprechend den Pfeilen 5 auf ihrer Rückseite kurzzeitig lokal erhitzt. Das Emissionsmaterial wird dadurch durch Sublimation auf dem Display-Substrat 3 abgeschieden. Dabei können Temperaturen angewendet werden, die zwischen 100 °C und 500°C liegen. Das lokale Erhitzen kann durch feinstrukturierte elektrische Heizelemente oder durch Laserstrahlung bzw. intensive Lampenstrahlung, beispielsweise mit Halogenlampen, in Verbindung mit entsprechenden Optiken erfolgen. Dabei kann in beiden Fällen die Übertragung der Struktur sowohl für alle Pixel gleichzeitig als auch für einzelne Spalten oder Pixel nacheinander erfolgen. Die Ausdehnung des Bereiches, der dabei mit dem Emissionsmaterial beschichtet wird, entspricht aufgrund des geringen Abstands zwischen der Trägerfolie 1 und dem Display-Substrat 3 sehr genau der Ausdehnung des aufgeheizten Bereiches.

Zur Herstellung von einfarbigen Displays wird ein mit dem gewünschten Emissionsmaterial beschichteter Trägerfolien 1 verwendet. Wenn vollfarbige RGB-Displays hergestellt werden sollen, können drei Trägerfolien 1 verwendet werden, von denen jede mit einem der Emissionsmaterialien beschichtet ist. Die Trägerfolien 1 werden dann nacheinander in die richtige Position gegenüber dem Display-Substrat 3 gebracht und lokal erhitzt. Es ist aber auch möglich, eine Trägerfolie 1 in nebeneinander liegenden Bereichen mit den unterschiedlichen Emissionsmaterialien zu beschichten. Für die Sublimationsschritte braucht die Trägerfolie 1 dann nur entsprechend verschoben zu werden.

Zur Einstellung der Emissionsfarbe kann die Trägerfolie 1 auch in zwei aufeinanderfolgenden Schritten mit niedermolekularen Materialien so beschichtet werden, dass dieselben nicht durchmischt sind. Das sind beispielsweise ein Wirtsmaterial A und ein gegenüber demselben unterschiedliches Gastmaterial B. Nach dem Sublimationsschritt ergibt sich auf dem Display-Substrat 3 eine durchmischte Schicht, in der das Wirtsmaterial A mit dem Gastmaterial B dotiert ist. Eine Lichtemission erfolgt aus dem Gastmaterial B, das-die Emissionsfarbe bestimmt.

Das Verfahren kann darüber hinaus auch für niedermolekulare Materialien eingesetzt werden, die den Transport oder die Injektion von elektrischen Ladungsträgern verbessern. Ein geeignetes Material ist beispielsweise 4,4',4"-Tris (N-(1-naphtyl)-N-phenyl-amino)-triphenylamin (kurz: TNATA, Lochtransportmaterial).

## Patentansprüche

1. Verfahren zur Mikrostrukturierung mittels ortsselektiver Sublimation, mit welchem zur Herstellung von Mustern oder Bildern aus organischen Elektrolumineszenz-Bauelementen auf einem Träger vorhandenes Emissionsmaterial durch Sublimation an den Stellen eines Substrats aufgetragen wird, die einem zu erzeugenden Muster oder Bild entsprechen, mit welchem dazu zunächst ein Träger (1) aus temperaturbeständigem Material ganzflächig mit Emissionsmaterial beschichtet wird, mit welchem danach der beschichtete Träger (1) und das Substrat (3) in einer Vakuumkammer (4) dicht nebeneinander und parallel zueinander positioniert werden, wobei die mit Emissionsmaterial beschichtete Seite des Trägers (1) dem Substrat (3) zugewandt ist, und mit welchem anschließend der Träger (1) auf seiner nicht beschichteten Seite lokal an den Stellen, welche dem auf dem Substrat (3) zu erzeugenden Muster oder Bild entsprechen, kurzzeitig auf eine für die Sublimation des Emissionsmaterials ausreichende Temperatur erhitzt wird, **dadurch gekennzeichnet,**
- **dass** als Emissionsmaterial niedermolekulares Emissionsmaterial verwendet wird und
- **dass** der Träger (1) mit zwei oder mehr aufeinanderfolgenden Schichten aus unterschiedlichen niedermolekularen Materialien so beschichtet wird, dass die unterschiedlichen Materialien der Schichten nicht durchmischt sind, während sie nach dem Sublimationsschritt auf dem Substrat (3) eine durchmischte Schicht bilden.

2. Verfahren nach Anspruch 1, **dadurch gekennzeichnet, dass** als Träger (1) eine Polyimid-Folie verwendet wird.

3. Verfahren nach Anspruch 1 oder 2, **dadurch gekennzeichnet, dass** für die lokale Erhitzung des Trägers (1) ein strukturiertes elektrisches Heizelement verwendet wird.

4. Verfahren nach Anspruch 1 oder 2, **dadurch gekennzeichnet, dass** für die lokale Erhitzung des Trägers (1) Laserstrahlung bzw. Lampenstrahlung in Verbindung mit entsprechenden Optiken verwendet wird.

5. Verfahren nach Anspruch 1, **dadurch gekennzeichnet, dass** als niedermolekulare Materialien jeweils Materialien verwendet werden, die den Transport bzw. die injection von elektrischen Ladungsträgern verbessern.

## Claims

1. A method for microstructuring by means of locally selective sublimation, whereby patterns or images of organic electroluminescent components are produced by applying the emissions material on a support by means of sublimation to those areas of a substrate which correspond to a pattern or image to be produced, by which first a support (1) made of a temperature resistant material is completely coated with emissions material, by which the coated support (1) and the substrate (3) are then placed closely adjacent and parallel to each other in a vacuum chamber (4), where the side of the support (1) that is coated with the emissions material faces the substrate (3), and by which the side of the support
(1) that is not coated is then briefly and locally heated in the areas that correspond to the pattern or image to be produced on the substrate (3), to a temperature that is sufficient for the sublimation of the emissions material,
**characterized in that**
- a low-molecular emissions material is used as emissions material and
- the support (1) is coated with two or more consecutive layers of different low-molecular materials in a way so that the different materials of the layers are not intermixed, while they form a mixed layer on the substrate (3) after the sublimation step.

2. A method according to claim 1, **characterized in that** a polyimide film is used for the support (1).

3. A method according to claim 1 or 2, **characterized in that** a structured electrical heating element is used to heat the support (1) locally.

4. A method according to claim 1 or 2, **characterized in that** laser radiation or lamp radiation in conjunction with corresponding optics are used to heat the support (1) locally.

5. A method according to claim 1, **characterized in that** the low-molecular materials are materials which improve the transport or the injection of electrical charge carriers.

## Revendications

1. Procédé de microstructuration au moyen de la sublimation avec sélection de l'emplacement, avec lequel, pour fabriquer des motifs ou des images à partir de composants électroluminescents organiques, le matériel d'émission existant est appliqué par sublimation sur un support aux endroits d'un substrat qui correspondent à un motif ou à une image à générer, avec lequel un support (1) en matériau résistant à la température est tout d'abord recouvert à cet effet sur toute sa surface d'un matériau d'émission, avec lequel le support (1) revêtu et le substrat (3) sont ensuite positionnés dans une chambre sous vide (4) proches l'un de l'autre et parallèlement l'un à l'autre, le côté du support (1) recouvert de matériau d'émission faisant face au substrat (3), et avec lequel le support (1) est ensuite réchauffé sur son côté non revêtu, localement aux endroits qui correspondent au motif ou à l'image à générer sur le substrat (3), pendant un court instant à une température suffisante pour la sublimation du matériel d'émission, **caractérisé en ce**
- **que** la matériau d'émission utilise est un matériau d'émission de faible poids moléculaire et
- **que** le support (1) est recouvert de deux couches successives où plus de différents matériaux de faible poids moléculaire de telle sorte que les différents matériaux des couches ne sont pas mélangés alors qu'ils forment, après l'étape de sublimation, une couche mélangée sur le substrat (3).

2. Procédé selon la revendication 1, **caractérisé en ce que** le support (1) utilisé est un film de polyimide.

3. Procédé selon la revendication 1 ou 2, **caractérisé en ce qu'**un élément chauffant électrique structuré est utilisé pour le chauffage local du support (1).

4. Procédé selon la revendication 1 ou 2, **caractérisé en ce qu'**un rayonnement laser ou un rayonnement de lampes combiné avec des optiques en conséquence est utilisé pour le chauffage local du support (1).

5. Procédé selon la revendication 1, **caractérisé en ce que** les matériaux de faible poids moléculaire employés sont à chaque fois des matériaux qui améliorent le transport ou l'injection des porteurs de charge électrique.
